# EUROPÄISCHE PATENTSCHRIFT

(11) **EP 1 439 551 B1**
(45) Veröffentlichungstag und Bekanntmachung des Hinweises auf die Patenterteilung: **26.07.2006**
(21) Anmeldenummer: 03026407.1
(22) Anmeldetag: 19.11.2003
(51) Int. Cl.: H01F 17/04, H05K 3/30

(54) **Induktives Miniatur-Bauelement für SMD-Montage**
SMD inductive miniature component
Composant miniature inductif du type SMD

(30) Priorität: 16.01.2003 DE 20300713 U
(43) Veröffentlichungstag der Anmeldung: 21.07.2004
(73) Patentinhaber: NEOSID Pemetzrieder GmbH & Co. KG, 58553 Halver (DE)
(72) Erfinder: Swoboda, Eugeniusz, 58644 Iserlohn (DE); Höller, Karl-Heinz, 42477 Radevormwald (DE)
(74) Vertreter: Feder, Wolf-Dietrich

(56) Entgegenhaltungen:
- EP-A- 0 282 646
- EP-A- 0 696 092
- US-A- 4 489 487
- US-A- 4 806 895

## Beschreibung

Die Erfindung betrifft ein induktives Miniatur-Bauelement für SMD-Montage mit einem einteiligen Ferritkern, dessen Länge grösser ist als seine Breite, und mit mindestens einer um den Kern herum angeordneten Spulenwicklung mit elektrischen Anschlusselementen.

Bei derartigen Bauelementen, die beispielsweise als langgestreckte Spulen mit dünnen Ferritkernen ausgebildet sein können, hat sich herausgestellt, dass insbesondere die Ferritkerne ausserordentlich bruchempfindlich sind, so dass sie, wenn sie in eine zu steuernde Vorrichtung, beispielsweise in Uhren, eingebaut sind, beim Auftreten starker Stösse, wie sie beispielsweise beim Herunterfallen der Vorrichtung auftreten können, leicht zerbrechen.

Ein induktives Miniatur-Bauelement gemäß dem Oberbegriff des Anspruchs 1 ist in EP-A-0 282 646 offenbart.

Der Erfindung liegt die Aufgabe zugrunde, ein induktives Miniatur-Bauelement der oben und im Oberbegriff des Patent anspruchs 1 erwähnten Bauart so auszugestalten, dass im eingebauten Zustand eine Stabilisierung des Bauelements, insbesondere des Ferritkerns, erreicht wird, durch welche die Bruchempfindlichkeit stark herabgesetzt wird.

Die Lösung dieser Aufgabe erfolgt erfindungsgemäß dadurch, dass das Bauelement mindestens an einer in seiner Längsrichtung verlaufenden Oberfläche mit einer sich mindestens über einen Teilabschnitt seiner Länge erstreckenden Beschichtung versehen ist, die aus einem Material besteht, dessen Schmelzpunkt unterhalb der Temperatur liegt, die am Bauelement beim Verlöten der elektrischen Anschlusselemente mit den Leiterbahnen einer Leiterplatte auftritt derart, dass das Beschichtungsmaterial sich zeitweise verflüssigt und eine den Ferritkern stabilisierende Verbindung zwischen Bauelement und Leiterplatte bildet.

Diese Ausbildung des Bauelements hat den Vorteil, dass beim Einsetzen des Bauteils auf die Leiterplatte bzw. Platine und beim Verlöten der elektrischen Anschlusselemente das Beschichtungsmaterial verfliesst und nach dem Wiedererhärten das Bauelement automatisch fest an der Leiterplatte fixiert, wodurch auch der Ferritkern stabilisiert ist.

Weiterhin wird durch die erfindungsgemäße Ausbildung des Bauelements eine Entlastung der Verbindung zwischen den elektrischen Anschlusselementen und der Leiterplatte erreicht, so dass die Gefahr verringert ist, dass sich das Bauteil von der Leiterplatte löst.

Das Bauelement kann an seiner Oberseite und mindestens einem Teil der Seitenflächen mit dem Beschichtungsmaterial versehen sein, es kann aber auch an seiner bei der Montage der Leiterplatte zugekehrten Unterseite mit dem Beschichtungsmaterial versehen sein. Schliesslich kann das Bauelement auch rundherum von dem Beschichtungsmaterial umschlossen sein.

Insbesondere bei einer an der Unterseite des Bauelements angeordneten Beschichtung kann das Beschichtungsmaterial auch in Form eines Folienstreifens am Bauelement befestigt sein. Hierbei kann der Folienstreifen entweder mittels eines selbstklebenden Films oder mittels eines aushärtbaren Klebstoffes am Bauelement befestigt sein.

Der Schmelzpunkt des Beschichtungsmaterials liegt vorzugsweise zwischen 130 und 220 °C.

Es hat sich herausgestellt, dass als Beschichtungsmaterial beispielsweise ein Schmelzkleber auf der Basis thermoplastischer Co-Polyesterharze verwendet werden kann.

Weiterhin kann als Beschichtungsmaterial eine Vergussmasse auf der Basis eines thermoplastischen Polyamids oder ein Schmelzklebstoff auf der Basis eines thermoplastischen Polyamidharzes verwendet werden.

Derartige im Handel erhältliche Schmelzkleber, Vergussmassen und Schmelzklebstoffe besitzen Schmelzpunkte und Erweichungspunkte im oben angegebenen Temperaturbereich und eignen sich in hervorragender Weise als Beschichtungsmaterial für das erfindungsgemässe Miniatur-Bauelement.

Im folgenden werden anhand der beigefügten Zeichnungen Ausführungsbeispiele von induktiven Miniatur-Bauelementen für SMD-Montage nach der Erfindung näher erläutert.

In den Zeichnungen zeigen:
Fig. 1 ein induktives Miniatur-Bauelement in Seitenansicht in seiner Längsrichtung;
Fig. 2 das induktive Miniatur-Bauelement nach Fig. 1 in Seitenansicht in seiner Querrichtung;
Fig. 3 das induktive Miniatur-Bauelement nach Fig. 1 und 2 in einer Aufsicht.
Fig. 4 in einer Darstellung analog Fig. 1 eine andere Ausführungsform eines induktiven Miniatur-Bauelements;
Fig. 5 das induktive Miniatur-Bauelement nach Fig. 4 in einer Darstellung analog Fig. 2;
Fig. 6 das induktive Miniatur-Bauelement nach Fig. 4 in einer Darstellung analog Fig. 3;
Fig. 7 im Querschnitt ein induktives Miniatur-Bauelement im auf einer Platine befestigten Zustand;
Fig. 8 das induktive Miniatur-Bauelement nach Fig. 7 im auf einer Platine befestigten Zustand in Seitenansicht in seiner Querrichtung.

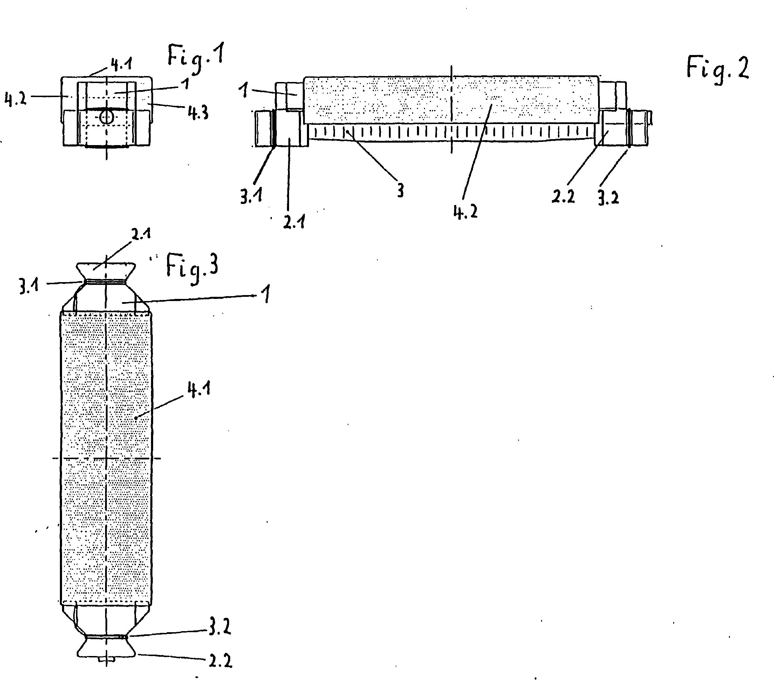

Das in den Fig. 1 bis 3 dargestellte induktive Miniatur-Bauelement besitzt einen in seiner Längsrichtung verlaufenden, als dünner Stab mit rechteckigem Querschnitt ausgebildeten Ferritkern 1 mit Ansatzfüssen 2.1 und 2.2 an beiden Enden. Auf den Kern ist eine Spulenwicklung 3 aufgebracht, deren Spulenenden zur Bildung elektrischer Anschlusselemente 3.1 und 3.2 um die Ansatzfüsse 2.1 und 2.2 gewickelt sind.

Das Bauelement ist an seiner Oberseite und den beiden Seitenflächen mit einer Beschichtung versehen, die somit einen oberen Abschnitt 4.1 und an den Seitenwänden Abschnitte 4.2 und 4.3 aufweist, die über einen Teil der Seitenfläche nach unten reichen.

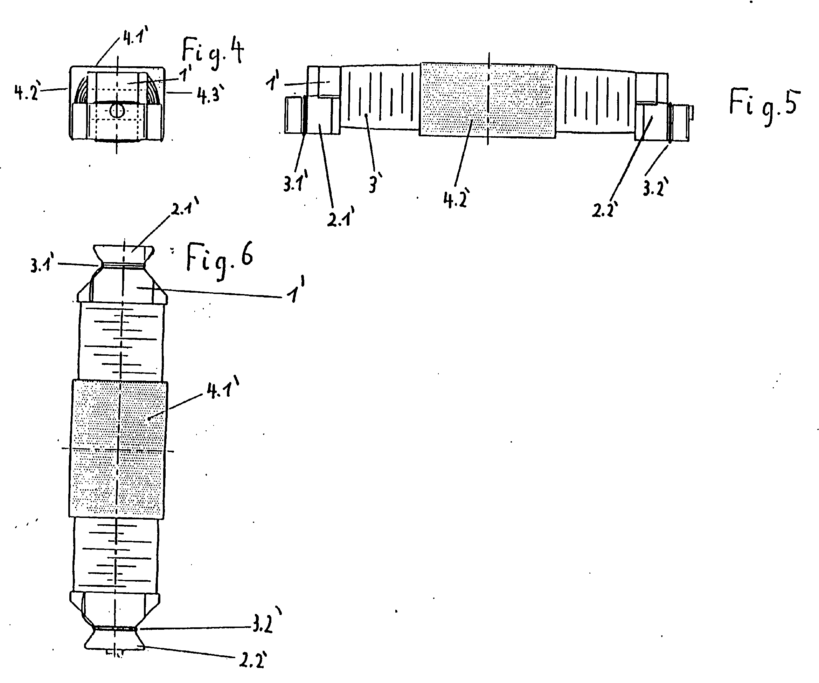

Die an dem Bauelement angeordnete Beschichtung muss sich nicht notwendig über die gesamte Länge des Bauelements erstrecken, sondern sie kann sich auch über einen Teilabschnitt seiner Länge, also beispielsweise über ein Drittel der Gesamtlänge, erstrecken. In den Fig. 4 bis 6 ist ein derartiges Ausführungsbeispiel dargestellt. In den Fig. 4 bis 6 sind für gleiche Teile die gleichen Bezugsziffern verwendet und mit einem Apostrophstrich versehen. Auch bei diesem Ausführungsbeispiel besitzt die Beschichtung einen oberen Abschnitt 4.1' und an den Seitenwänden Abschnitte 4.2' und 4.3'. Die Beschichtung erstreckt sich aber nur über einen Teilabschnitt der gesamten Länge, der im wesentlichen symmetrisch zur Längsmitte liegt.

Beim Aufsetzen dieser induktiven Miniatur-Bauelemente auf eine Leiterplatte bzw. Platine werden die elektrischen Anschlüsse 3.1 und 3.2 bzw. 3.1' und 3.2' mit Leiterbahnen der Platine verlötet. Dabei erwärmt sich das Bauelement und insbesondere der Ferritkern insgesamt. Das verwendete Beschichtungsmaterial besitzt einen Schmelzpunkt, der so gewählt ist, dass die aufgebrachte Beschichtung beim Verlöten und dem damit verbundenen Erwärmen des gesamten Bauelements mindestens teilweise aufschmilzt, dabei teilweise herab auf die Leiterplatte fliesst und nach dem Wiedererkalten und Erhärten eine feste stabilisierende Verbindung zwischen Bauelement und Leiterplatte schafft, durch welche auch der Ferritkern 1 stabilisiert wird, so dass seine Bruchempfindlichkeit erheblich herabgesetzt ist.

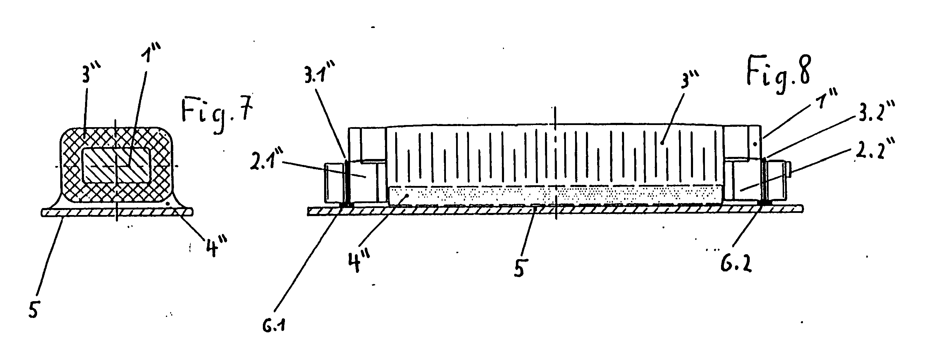

In den Fig. 7 und 8 ist der Zustand eines induktiven Miniatur-Bauelements der oben beschriebenen Art nach dem Aufsetzen auf eine Platine 5 und dem Verbinden der Anschlusselemente 3.1 " und 3.2" über Lötstellen 6.1 und 6.2 mit den Leiterbahnen der Platine 5 dargestellt. Auch dieses induktive Miniatur-Bauelement besitzt einen Ferritkern 1 " mit Ansatzfüssen 2.1 " und 2.2" an beiden Enden, und auf den Kern ist eine Spulenwicklung 3" aufgebracht, deren Spulenenden zur Bildung der elektrischen Anschlusselemente 3.1" und 3.2" um die Ansatzfüsse 2.1 " und 2.2" gewickelt sind.

Das Beschichtungsmaterial 4" war an der Unterseite des Bauelements aufgebracht, beispielsweise - wie oben erwähnt - in Form eines Folienstreifens. Bei der durch das Verlöten erfolgten Erwärmung des Bauelements ist die Beschichtung 4" teilweise aufgeschmolzen und bildet, wie aus Fig. 7 und 8 zu erkennen, eine stabile Verbindung zwischen dem Bauelement und der Platine 5. Durch diese stabile Verbindung wird zusätzlich eine Entlastung der Lötstellen 6.1 und 6.2 zwischen den elektrischen Anschlusselementen 3.1 " und 3.2" an den Ansatzfüßen 2.1 " und 2.2" und der Platine 5 erreicht und damit die Gefahr verringert, dass sich das Bauteil unter Unterbrechung der elektrischen Verbindung von der Platine 5 ablöst.

## Patentansprüche

1. Induktives Miniatur-Bauelement für SMD-Montage mit einem einteiligen Ferritkern, dessen Länge grösser ist als seine Breite, und mit mindestens einer um den Kern herum angeordneten Spulenwicklung mit elektrischen Anschlusselementen, **dadurch gekennzeichnet, dass** das Bauelement mindestens an einer in seiner Längsrichtung verlaufenden Oberfläche mit einer sich mindestens über einen Teilabschnitt seiner Länge erstreckenden Beschichtung (4.1, 4.2, 4.3, 4.1', 4.2', 4.3') versehen ist, die aus einem Material besteht, dessen Schmelzpunkt unterhalb der Temperatur liegt, die am Bauelement beim Verlöten der elektrischen Anschlusselemente (3.1, 3.2, 3.1', 3.2') mit den Leiterbahnen einer Leiterplatte auftritt derart, dass das Beschichtungsmaterial sich zeitweise verflüssigt und nach dem Verfliessen und Wiederverfestigen eine den Ferritkern (1, 1') stabilisierende Verbindung zwischen Bauelement und Leiterplatte (5) entsteht.

2. Bauelement nach Anspruch 1, **dadurch gekennzeichnet, dass** das Bauelement an seiner Oberseite und mindestens einem Teil der Seitenflächen mit dem Beschichtungsmaterial (4.1, 4.2, 4.3) versehen ist.

3. Bauelement nach Anspruch 1 oder 2, **dadurch gekennzeichnet, dass** das Bauelement an seiner bei der Montage der Leiterplatte zugekehrten Unterseite mit dem Beschichtungsmaterial versehen ist.

4. Bauelement nach einem der Ansprüche 1 bis 3, **dadurch gekennzeichnet, dass** das Beschichtungsmaterial in Form eines Folienstreifens insbesondere an der Unterseite des Bauelements angeordnet ist.

5. Bauelement nach Anspruch 4, **dadurch gekennzeichnet, dass** der Folienstreifen am Bauelement mittels eines selbstklebenden Films befestigt ist.

6. Bauelement nach Anspruch 4, **dadurch gekennzeichnet, dass** der Folienstreifen am Bauelement mittels eines aushärtbaren Klebstoffs befestigt ist.

7. Bauelement nach einem der Ansprüche 1 bis 6, **dadurch gekennzeichnet, dass** der Schmelzpunkt des Beschichtungsmaterials bei 130 - 220 °C liegt.

8. Bauelement nach einem der Ansprüche 1 bis 7, **dadurch gekennzeichnet, dass** das Beschichtungsmaterial ein Schmelzkleber auf der Basis thermoplastischer Co-Polyesterharze ist.

9. Bauelement nach einem der Ansprüche 1 bis 7, **dadurch gekennzeichnet, dass** das Beschichtungsmaterial eine Vergussmasse auf der Basis eines thermoplastischen Polyamids ist.

10. Bauelement nach einem der Ansprüche 1 bis 7, **dadurch gekennzeichnet, dass** das Beschichtungsmaterial ein Schmelzklebstoff auf der Basis thermoplastischer Polyamidharze ist.

## Claims

1. Inductive miniature component for SMD assembly with a monolithic ferrite core the length of which is greater than its width, and with at least one coil winding disposed around the core with electrical connection elements, **characterised in that** the component has a coating (4.1, 4.2, 4.3, 4.1', 4.2', 4.3') extending over at least a partial section of its length on at least one surface running in the longitudinal direction of the component, said coating consisting of a material with a melting point below the temperature that occurs on the component when the electrical connection elements (3.1, 3.2, 3.1', 3.2') are soldered to the conductors of a printed circuit board, such that the coating material liquefies temporarily and, after liquefying and resetting, a bond stabilising the ferrite core (1, 1') forms between component and circuit board (5).

2. Component according to claim 1, **characterised in that** the component is provided with the coating material (4.1, 4.2, 4.3) on its upper side and at least a part of its lateral surfaces.

3. Component according to claim 1 or 2, **characterised in that** the component is provided with the coating material on its underside facing towards the circuit board during assembly.

4. Component according to one of claims 1 to 3, **characterised in that** the coating material is disposed in the shape of a foil strip especially on the underside of the component.

5. Component according to claim 4, **characterised in that** the foil strip is attached to the component by means of a self-adhesive film.

6. Component according to claim 4, **characterised in that** the foil strip is attached to the component by means of a hard-setting adhesive.

7. Component according to one of claims 1 to 6, **characterised in that** the melting point of the coating material is between 130 - 220 °C.

8. Component according to one of claims 1 to 7, **characterised in that** the coating material is a hot melt adhesive based on thermoplastic co-polyester resins.

9. Component according to one of claims 1 to 7, **characterised in that** the coating material is an embedding compound based on a thermoplastic polyamide.

10. Component according to one of claims 1 to 7, **characterised in that** the coating material is a hot melt adhesive material based on thermoplastic polyamide resins.

## Revendications

1. Composant miniature inductif pour montage en surface (SMD) comprenant un tore de ferrite d'une seule pièce, dont la longueur est supérieure à sa largeur, et au moins un enroulement de bobine disposé tout autour du tore avec des éléments de branchement électriques, **caractérisé en ce que** le composant est doté au moins sur une surface agencée dans sa direction longitudinale d'un revêtement (4.1, 4.2, 4.3, 4.1', 4.2', 4.3') s'étendant sur un tronçon partiel de sa longueur, qui est à base d'un matériau, dont le point de fusion est supérieur à la température qui apparaît sur le composant lors du soudage des éléments de branchement électriques (3.1, 3.2, 3.1', 3.2') avec les pistes conductives d'une carte à circuits imprimés, de telle sorte que le matériau de revêtement se liquéfie par moments et qu'une liaison stabilisant le tore de ferrite (1. 1') entre le composant et la carte à circuits imprimés (5) se forme après la liquéfaction et la resolidification.

2. Composant selon la revendication 1, **caractérisé en ce que** le composant est doté sur sa surface et au moins une partie des faces latérales du matériau de revêtement (4.1, 4.2, 4.3).

3. Composant selon la revendication 1 ou 2, **caractérisé en ce que** le composant est doté du matériau de revêtement sur sa face inférieure tournée lors du montage vers la carte à circuits imprimés.

4. Composant selon l'une quelconque des revendications 1 à 3, **caractérisé en ce que** le matériau de revêtement est disposé sous la forme d'une bande de feuille en particulier sur le côté inférieur du composant.

5. Composant selon la revendication 4, **caractérisé en ce que** la bande de feuille est fixée sur le composant au moyen d'un film autocollant.

6. Composant selon la revendication 4, **caractérisé en ce que** la bande de feuille est fixée sur le composant au moyen d'une colle durcissable.

7. Composant selon l'une quelconque des revendications 1 à 6, **caractérisé en ce que** le point de fusion du matériau de revêtement se situe entre 130 et 220°C.

8. Composant selon l'une quelconque des revendications 1 à 7, **caractérisé en ce que** le matériau de revêtement est une colle fusible à base de résines de co-polyester thermoplastiques.

9. Composant selon l'une quelconque des revendications 1 à 7, **caractérisé en ce que** le matériau de revêtement est une masse de scellement à base d'un polyamide thermoplastique.

10. Composant selon l'une quelconque des revendications 1 à 7, **caractérisé en ce que** le matériau de revêtement est une colle fusible à base de résines de polyamides thermoplastiques.
